# EUROPEAN PATENT SPECIFICATION

(11) **EP 3 316 473 B1**
(45) Date of publication and mention of the grant of the patent: **27.01.2021**
(21) Application number: 17199190.4
(22) Date of filing: 30.10.2017
(51) Int. Cl.: H02N 2/18

(54) **METHOD AND DEVICE FOR CONTROLLING VIBRATION OF MOTOR**
VERFAHREN UND VORRICHTUNG ZUR STEUERUNG DER VIBRATION EINES MOTORS
PROCÉDÉ ET DISPOSITIF DE COMMANDE DE VIBRATION DE MOTEUR

(30) Priority: 31.10.2016 WO PCT/CN2016/104057
(43) Date of publication of application: 02.05.2018
(73) Proprietor: Beijing Xiaomi Mobile Software Co., Ltd., Beijing 100085 (CN)
(72) Inventor: XIE, Fei, Beijing, 100085 (CN); DUAN, Weiliang, Beijing, 100085 (CN); LIU, Huanhuan, Beijing, 100085 (CN)
(74) Representative: dompatent von Kreisler Selting Werner - Partnerschaft von Patent- und Rechtsanwälten mbB

(56) References cited:
- JP-A- 2002 039 075
- JP-A- 2009 038 515
- US-A1- 2013 043 987

## Description

### TECHNICAL FIELD

The present disclosure relates to the technical field of electronics, and more particularly, to a method and a device for controlling vibration of a motor.

### BACKGROUND

A motor of a mobile phone is driven by a driving voltage to vibrate. The motor may be connected with a drive circuit via a wire which has resistance. Thus, a voltage actually used by the motor may be lower than a voltage outputted by the drive circuit. A drive circuit with an open-loop structure may not be able to receive a feedback value for vibration of the motor Prior art examples may be found in patent application documentsUS2013/043987 and JP2002039075.

### SUMMARY

Methods and apparatuses for controlling vibration of a motor are provided according to examples of the present disclosure.

According to an embodiment of the present disclosure, a method of controlling vibration of a motor is according to claim 1.

In an example, determining the first driving parameter includes: determining a feature parameter of the motor in the vibration mode according to the vibration information; determining a second driving parameter corresponding to the feature parameter in the vibration mode based on the preset reference information; determining the first driving parameter according to the second driving parameter.

In an example, determining the first driving parameter according to the second driving parameter includes: determining whether the feature parameter that corresponds to the second driving parameter reaches a maximum value of the feature parameter included in the preset reference information; determining a driving parameter outputted by the drive circuit to make the feature parameter of the motor reach the maximum value as the first driving parameter when the feature parameter that corresponds to the second driving parameter reaches the maximum value of the feature parameter included in the preset reference information.

In an example, the method further includes determining a preset range for the driving parameter for the motor; controlling the drive circuit to sequentially output driving parameters at a preset interval within the preset range to drive the motor. And collecting the vibration information generated by the motor in the vibration mode includes: collecting the vibration information generated by the motor driven using the driving parameters at the preset interval.

In an example, determining the first driving parameter according to the second driving parameter includes: determining a difference between the second driving parameter and a preset third driving parameter, wherein the third driving parameter is a driving parameter used by the motor to operate in the stable state; determining the first driving parameter based on the second driving parameter and the difference.

In an example, determining the first driving parameter based on the second driving parameter and the difference includes: determining whether an absolute value of the difference is no less than a preset threshold; adjusting the first driving parameter according to the difference when the absolute value is no less than the preset threshold, such that the absolute value of the difference between the second driving parameter and the preset third driving parameter is less than the preset threshold; controlling the drive circuit to drive the motor using the first driving parameter when the absolute value is less than the preset threshold.

According to an embodiment of the present disclosure, a device for controlling vibration of a motor according to claim 7 is provided.

In an example, the processor is caused by the machine-executable instructions to: determine a feature parameter of the motor in the vibration mode according to the vibration information; determine a second driving parameter corresponding to the feature parameter in the vibration mode based on the preset reference information; determine the first driving parameter according to the second driving parameter.

In an example, the machine- executable instructions further cause the processor to: determine whether the feature parameter that corresponds to the second driving parameter reaches a maximum value of the feature parameter included in the preset reference information; determine a driving parameter outputted by the drive circuit to make the feature parameter of the motor reach the maximum value as the first driving parameter when the feature parameter that corresponds to the second driving parameter reaches the maximum value of the feature parameter included in the preset reference information.

In an example, the machine-executable instructions further cause the processor to: determine a preset range for the driving parameter for the motor; control the drive circuit to sequentially output driving parameters at a preset interval within the preset range to drive the motor; and collect the vibration information generated by the motor driven using the driving parameters at the preset interval.

In an example, the machine-executable instructions further cause the processor to: determine a difference between the second driving parameter and a preset third driving parameter, wherein the third driving parameter is a driving parameter used by the motor to operate in the stable state; determine the first driving parameter based on the second driving parameter and the difference.

In an example, the machine-executable instructions further cause the processor to: determine whether an absolute value of the difference is no less than a preset threshold; adjust the first driving parameter according to the difference when the absolute value is no less than the preset threshold, such that the absolute value of the difference between the second driving parameter and the preset third driving parameter is less than the preset threshold; control the drive circuit to drive the motor with the first driving parameter when the absolute value is less than the preset threshold.

The machine- executable instructions further cause the processor to: determine the type of the motor according to driving information of the drive circuit using an electronic device.

It should be understood that the above general descriptions and the following detailed descriptions are merely illustrative and interpretive rather than limiting to the present disclosure.

### BRIEF DESCRIPTION OF DRAWINGS

Drawings herein are incorporated in and constitute a part of the description. The drawings illustrate one or more examples consistent with the present disclosure, and explain principles of the present disclosure together with the description.
FIG. 1A is a flowchart illustrating a method of controlling vibration of a motor according to an example of the present disclosure.
FIG. 1B is a schematic diagram illustrating a structure of a circuit for controlling vibration of a motor according to an example of the present disclosure.
FIG. 2 is a flowchart illustrating a method of controlling vibration of a motor according to another example of the present disclosure.
FIG. 3A is a flowchart illustrating a method of controlling vibration of a motor according to a further example of the present disclosure.
FIG. 3B is a schematic diagram illustrating a correspondence between a gravitational acceleration and a driving parameter of a drive circuit according to an example of the present disclosure.
FIG. 3C is a schematic diagram illustrating distribution of a gravitational acceleration of a motor in a vibration mode according to an example of the present disclosure.
FIG. 4A is a flowchart illustrating a method of controlling vibration of a motor according to yet another example of the present disclosure.
FIG. 4B is a schematic diagram illustrating distribution of a gravitational acceleration of a motor in a vibration mode according to another example of the present disclosure.
FIG. 5 is schematic diagram illustrating a structure of an apparatus for controlling vibration of a motor according to an example of the present disclosure.
FIG. 6 is schematic diagram illustrating a structure of an apparatus for controlling vibration of a motor according to another example of the present disclosure.
FIG. 7 is schematic diagram illustrating a structure of an apparatus for controlling vibration of a motor according to a further example of the present disclosure.
FIG. 8 is a schematic diagram illustrating a hardware structure of a device for controlling vibration of a motor according to an example of the present disclosure.

### DETAILED DESCRIPTION

Example embodiments will be described in detail herein with the examples thereof expressed in the drawings. When the following descriptions involve the drawings, like numerals in different drawings represent like or similar elements unless stated otherwise. The implementations described in the following example embodiments do not represent all implementations consistent with the present disclosure. On the contrary, they are examples of an apparatus and a method consistent with some aspects of the present disclosure described in detail in the appended claims.

The terminology used in the present disclosure is for the purpose of describing examples only and is not intended to limit the present disclosure. As used in the present disclosure and the appended claims, the singular forms "a," "an" and "the" are intended to include the plural forms as well, unless the context clearly indicates otherwise. It shall also be understood that the terms "or" and "and/or" used herein are intended to signify and include any or all possible combinations of one or more of the associated listed items, unless the context clearly indicates otherwise.

It shall be understood that, although the terms "first," "second," "third," and the like may be used herein to describe various information, the information should not be limited by these terms. These terms are only used to distinguish one category of information from another. For example, without departing from the scope of the present disclosure, first information may be termed as second information; and similarly, second information may also be termed as first information. As used herein, the term "if' may be understood to mean "when" or "upon" or "in response to" depending on the context.

References throughout this specification to "one embodiment," "an embodiment," "exemplary embodiment," or the like in the singular or plural means that one or more particular features, structures, or characteristics described in connection with an example is included in at least one embodiment of the present disclosure. Thus, the appearances of the phrases "in one embodiment," "in an embodiment," "in an exemplary embodiment," or the like in the singular or plural in various places throughout this specification are not necessarily all referring to the same embodiment. Furthermore, the particular features, structures, or characteristics in one or more embodiments may be combined in any suitable manner.

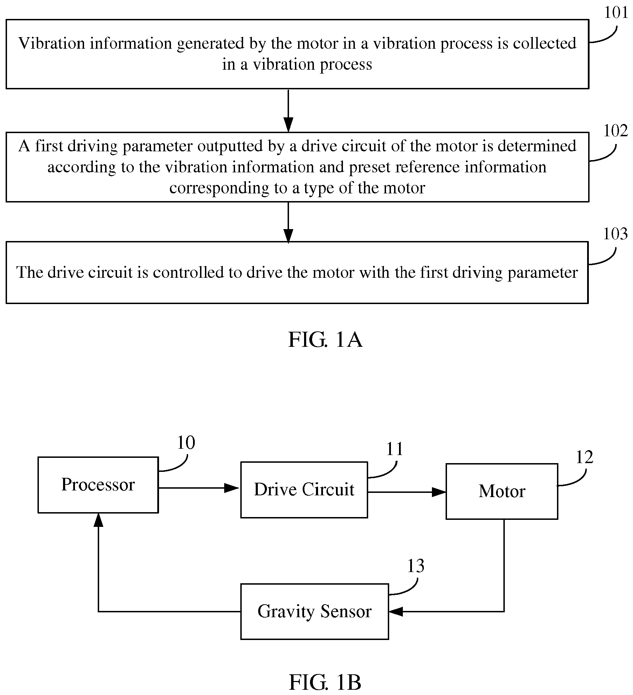

FIG. 1A is a flowchart illustrating a method of controlling vibration of a motor according to an example of the present disclosure. FIG. 1B is a schematic diagram illustrating a structure of a circuit for controlling vibration of a motor according to an example in FIG. 1A. The method of controlling the vibration of the motor may apply to an electronic device which can perform vibration by means of a motor, e.g., a smart phone and a tablet computer. In FIG. 1A, the method may include procedures as follows.

At step 101, vibration information generated by the motor in a vibration mode is collected in a vibration mode.

In an example, the vibration information generated by the motor when the motor is in the vibration mode may be collected by a gravity sensor, thus, the vibration information is a gravitational acceleration. When the motor drives an electronic device to vibrate, change of the collected vibration information is consistent with change of motor vibration. For example, when motor vibration strength reaches a maximum value, amplitude of the gravitational acceleration reaches a maximum value. Further, a direction of the motor vibration is same as a direction of the gravitational acceleration.

At step 102, a first driving parameter outputted by a drive circuit of the motor is determined according to the vibration information and preset reference information corresponding to a type of the motor. The preset reference information may include a correspondence between a feature parameter of motor when the motor is working in a stable state and a driving parameter used by drive circuit.

In the example, the preset reference information may be a correspondence between a feature parameter of motor operating in a stable state and a driving parameter used by the drive circuit in an ideal condition. In the ideal condition, there is no resistance on the wire between a drive circuit and a motor. In another example, the preset parameter information may be a correspondence between a feature parameter of motor that operates in a stable state and a driving parameter used by the motor that the motor is working in the stable state.

The drive circuit outputs the first driving parameter to make the motor work in a desired stable state. The first driving parameter may also be referred to as a target driving parameter of the drive circuit. Drive circuits corresponding to different types of motors may output different driving parameters. For example, when the type of the motor is a direct current motor, the driving parameter of the drive circuit is a driving voltage. When the type of the motor is an alternating current motor, the driving parameter of the drive circuit includes a driving voltage and a frequency corresponding to the driving voltage.

In an example, the preset parameter information may include the correspondence between the feature parameter of the motor operating in the stable state and the driving parameter used by the drive circuit by means of a list or a graph, and the correspondence may be obtained through experiments.

At step 103, the drive circuit is controlled to drive the motor with the first driving parameter.

In an example, the feature parameter indicates a vibration feature of the motor. In FIG. 1B, the vibration information which includes the gravitational acceleration is taken as an example. In a process that a processor 10 controls a drive circuit 11 to drive a motor 12 to vibrate, a gravity sensor 13 collects a gravitational acceleration of the motor 12 in the vibration mode. After receiving the gravitational acceleration collected by the gravity sensor 13, the processor 10 identifies the gravitational acceleration as the feature parameter, determines which driving parameter value is desired for the drive circuit 11 to drive the motor 12 to work in a way that the motor 12 works in the stable state, where the feature parameter may be an amplitude of the gravitational acceleration or a frequency of the gravitational acceleration.

In examples of the present disclosure, the first driving parameter for the drive circuit is determined to drive the motor according to the vibration information, and the drive circuit is controlled to drive the motor with the first driving parameter. There is a difference between the driving parameter used by the motor and the driving parameter provided by the drive circuit, which may be caused by wire resistance between the drive circuit and the motor. According to examples of the present disclosure, the difference can be compensated by replacing an electric signal with the vibration information which has a mechanical property in a way that the drive circuit with an open-loop structure can control the motor to work in an optimum vibration state. Compared with a drive circuit with a closcd-loop structure, the present disclosure provides the stable vibration performance for the motor while a structure of the drive circuit is simplified according to solutions of the present disclosure.

The process of determining the first driving parameter for the drive circuit of the motor according to the vibration information and the preset reference information corresponding to the type of the motor includes procedures as follows. A feature parameter of the motor in the vibration mode is determined according to the vibration information. A second driving parameter corresponding to the feature parameter in the vibration mode is determined based on the preset reference information corresponding to the type of the motor. The first driving parameter of the drive circuit is determined according to the second driving parameter.

In an example, the first driving parameter is a driving parameter outputted by the first driving parameter to make the motor work in a desired stable state (e.g., a target driving parameter of the drive circuit), the second driving parameter is a driving parameter actually used by the motor, which is determined based on the preset reference information. In the example above, the target driving parameter of the drive circuit (the first driving parameter) is determined based on the driving parameter actually used by the motor (the second driving parameter).

In an example, the process of determining the first driving parameter of the drive circuit according to the second driving parameter includes procedures as follows. It is determined whether the feature parameter corresponding to the second driving parameter reaches a maximum value of the feature parameter included in the preset reference information. When the feature parameter corresponding to the second driving parameter reaches the maximum value of the feature parameter included in the preset reference information, a driving parameter outputted by the drive circuit to make the feature parameter of the motor reach the maximum value is determined as the first driving parameter of the drive circuit.

In an example, before the vibration information generated by the motor in the vibration mode is collected by the gravity sensor, the method may further include procedures as follows. A preset range for the driving parameter used by the motor is determined. The drive circuit may be controlled to sequentially output driving parameters at a preset interval within the preset range in a way that the motor is sequentially driven by the driving parameters received sequentially at the preset interval. In this case, the process of collecting the vibration information generated by the motor in the vibration mode may include: collecting the vibration information generated by the motor which is driven with by driving parameters received sequentially at the preset interval.

In an example, the process of determining the first driving parameter of the drive circuit according to the second driving parameter includes procedures as follows. A difference between the second driving parameter and a preset third driving parameter is determined, where the third driving parameter is a driving parameter of the motor when the motor is working in a stable state. The first driving parameter is determined based on the second driving parameter and the difference.

In an example, the third driving parameter is a driving parameter used by the motor when the motor is working in a desired stable state.

In an example, the process of determining the first driving parameter of the drive circuit based on the second driving parameter and the difference includes procedures as follows. It is determined whether the absolute value of the difference is no less than a preset threshold. The first driving parameter is adjusted according to the absolute value of the difference when the absolute value of the difference is no less than the preset threshold. The adjustment may be repeated until the absolute value of the difference between the second driving parameter and the third driving parameter is less than the preset threshold. And the process of controlling the drive circuit to drive the motor with the first driving parameter is executed when the absolute value of the difference is less than the preset threshold.

In an example, the method further includes procedures as follow. The drive circuit is controlled to drive the motor with an initial first driving parameter. The vibration information generated by the motor in the vibration mode when the drive circuit outputs the initial first driving parameter value is collected. The second driving parameter value is determined according to the vibration information and the preset reference information.

The method further includes determining the type of the motor according to driving information about the drive circuit using an electronic device.

In an example, the first driving parameter, the second driving parameter and the third driving parameter may be different driving parameter values of a same driving parameter. For example, the driving parameter is a driving voltage; the first driving parameter is a driving parameter value outputted by the drive circuit to make the motor work in a desired stable state; the second driving parameter is a driving parameter value actually used by the motor, which is determined based on the preset reference information; and the third driving parameter is a driving parameter used by the motor when the motor is working in the desired stable state.

In examples below, the control of the motor vibration is further described.

Based on the method above provided by an example of the present disclosure, the drive circuit with the open-loop structure can control the motor to work in the optimum vibration state. The stable vibration performance for the motor can be achieved while the structure of the drive circuit is simplified.

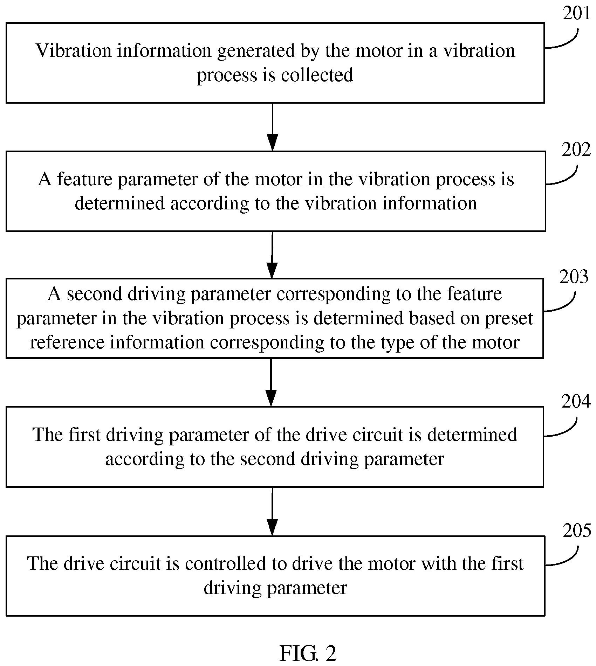

FIG. 2 is a flowchart illustrating a method of controlling vibration of a motor according to an example of the present disclosure. In the example, an alternating current motor is taken as an example of a type of the motor. In FIG. 2, the method includes steps as follows.

At step 201, vibration information generated by the motor in a vibration mode is collected.

Relevant procedures in step 201 is similar as that in the example above in FIG. 1A, which is not repeatedly described herein.

At step 202, a feature parameter of the motor in the vibration mode is determined according to the vibration information.

In an example, the feature parameter corresponds to the type of the motor. When the type of the motor is a direct current motor, the feature parameter is an amplitude of a gravitational acceleration. When the type of the motor is an alternating current motor, the feature parameter is a frequency of the gravitational acceleration, where the frequency in the vibration information is same as a vibration frequency of the motor. In the example, in the process of determining the driving parameter corresponding to the alternating current motor outputted by the drive circuit, one of a driving frequency and a driving voltage is fixed, and the other one may be adjusted according to the vibration information.

At step 203, a second driving parameter corresponding to the feature parameter in the vibration mode is determined based on preset reference information corresponding to the type of the motor, where the preset reference information may record a correspondence between a feature parameter of motor operating in the stable state and a driving parameter used by drive circuit.

The vibration information of each type of the motor operating in the stable state and the driving parameter of the drive circuit are obtained by experiments. The vibration information in the stable state and the driving parameter of the drive circuit may be recorded in the preset reference information. For example, the preset reference information is recorded by means of a list or a correspondence curve graph. In table 1, the driving parameter is a driving voltage, the vibration information is a gravitational acceleration, and the preset reference information is recorded by means of the list.

**Table 1**

| | | | | |
|---|---|---|---|---|
| Driving Voltage Used by Motor (V) | 2.7 | 2.9 | 3.0 | 3.3 |
| Gravitational Acceleration (N/kg) | 0.27 | 0.29 | 0.3 | 0.33 |

When different driving voltages are used by the motor, vibration strengths corresponding to the different driving voltages are different, which causes that amplitudes of the gravitational acceleration collected by the gravity sensor are different. Numerical values in table 1 above are merely illustrative, which is not the limitation of the present disclose.

At step 204, the first driving parameter of the drive circuit is determined according to the second driving parameter.

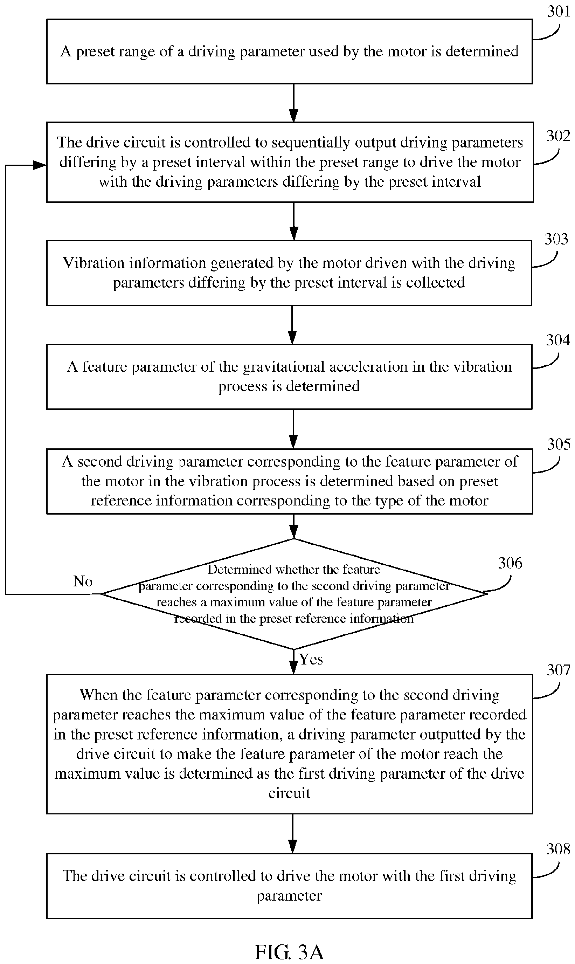

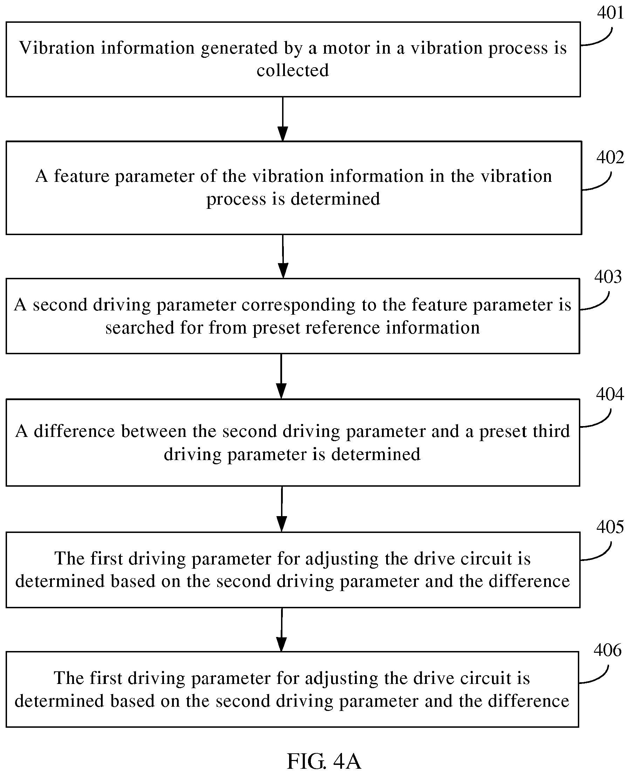

How to determine the first driving parameter of the drive circuit according to the second driving parameter is similar as that in the example in FIG. 3A or 4A below.

At step 205, the drive circuit is controlled to drive the motor with the first driving parameter.

Relevant procedures in step 205 are similar as that in the example in FIG. 1A, which is not repeatedly described herein.

In the example, the second driving parameter may be a driving parameter used by the motor working in the stable state. The second driving parameter corresponding to the feature parameter in the vibration mode is determined based on the preset reference information, and the first driving parameter used by the drive circuit is determined based on the second driving parameter. Thus, the drive circuit can consider wire resistance between the drive circuit and the motor when driving the motor to vibrate in a way that it can be ensured that the motor works in the optimum state.

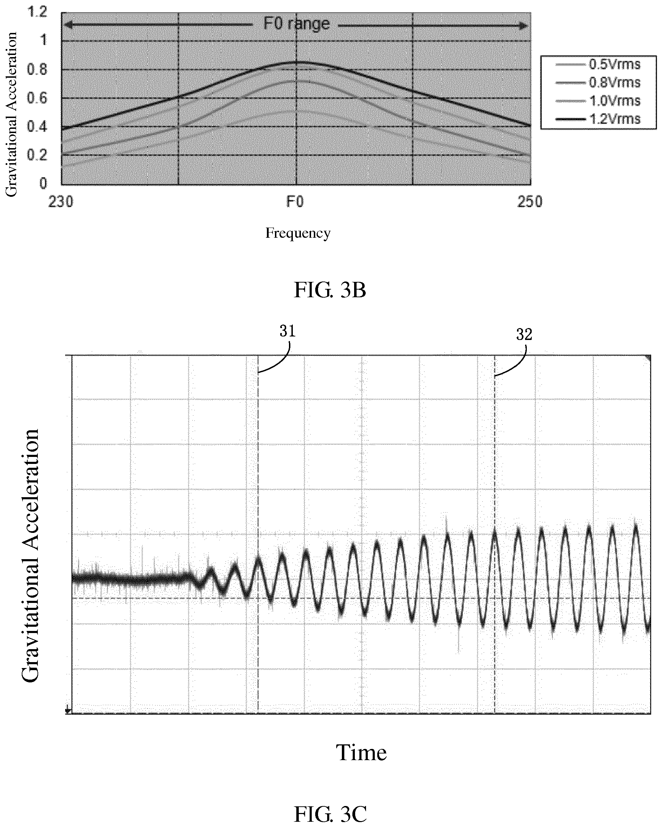

FIG. 3A is a flowchart illustrating a method of controlling vibration of a motor according to an example. FIG. 3B is a schematic diagram illustrating a correspondence between a gravitational acceleration and a driving parameter of a drive circuit according to an example in FIG. 3A. FIG. 3C is a schematic diagram illustrating distribution for a gravitational acceleration of a motor in a vibration mode according to an example in FIG. 3A. In the example, a type of the motor is an alternating current motor, the driving parameter is a frequency of a driving voltage outputted by the drive circuit, which is described in conjunction with FIG. 1B. In FIG. 3A, the method includes steps as follows.

At step 301, a preset range of a driving parameter used by the motor is determined.

In an example, since manufacturing techniques for different motors may be different, maximum vibration frequency points (i.e., point F0) for different alternating current motors may be different. A range of the maximum vibration frequency point (F0) for each alternating current motor may be obtained by testing the alternating-current motor before the alternating current motor leaves a factory. Thus, a frequency of a driving voltage outputted from a drive circuit to the motor can be adjusted according to the vibration information in the motor vibration mode.

At step 302, the drive circuit is controlled to sequentially output driving parameters at a preset interval within the preset range to drive the motor using the driving parameters received at the preset interval.

For example, in FIG. 3B, an amplitude of an alternating current voltage is fixed, e.g. 1.2V, a preset range for the frequency of the alternating current voltage used by the motor 12 is 230Hz to 250Hz, and a preset interval is 2Hz. Accordingly, a processor 13 drives the alternating current motor with frequency points from 230 Hz to 250 Hz, e.g., 232Hz, 234Hz, 236Hz, etc.

At step 303, vibration information generated by the motor driven using the driving parameters received at the preset interval is collected.

Corresponding to step 302 above, the vibration information includes a gravitational acceleration. The amplitude of the gravitational acceleration is changed along with a curve illustrated in FIG. 3B.

At step 304, a feature parameter of the gravitational acceleration in the vibration mode is determined.

In an example, the feature parameter is the frequency of the gravitational acceleration.

At step 305, a second driving parameter corresponding to the feature parameter of the motor in the vibration mode is determined based on preset reference information corresponding to the type of the motor, where the preset reference information may include a correspondence between a feature parameter of motor working in a stable state and a driving parameter used by drive circuit.

In an example, the preset reference information is expressed by a correspondence curve graph in FIG. 3B. Further, a correspondence between a discrete feature parameter and a discrete driving parameter may be obtained by sampling data according to the correspondence curve graph of relationship in FIG. 3B.

At step 306, it is determined whether the feature parameter corresponding to the second driving parameter reaches a maximum value of the feature parameter recorded in the preset reference information. When the feature parameter corresponding to the second driving parameter reaches the maximum value of the feature parameter recorded in the preset reference information, procedures in step 307 is executed. When the feature parameter corresponding to the second driving parameter does not reach the maximum of the feature parameter recorded in the preset reference information, procedures in step 302 is executed again.

At step 307, when the feature parameter corresponding to the second driving parameter reaches the maximum value of the feature parameter included in the preset reference information, a driving parameter outputted by the drive circuit to make the feature parameter of the motor reach the maximum value is determined as the first driving parameter of the drive circuit.

In an example, according to a correspondence between a gravitational acceleration and a frequency of a driving voltage in FIG. 3B, when the gravitational acceleration reaches a maximum value, a frequency point corresponding to the gravitational acceleration is a frequency point which causes the feature parameter of the motor vibration reach a maximum value. The maximum value of the gravitational acceleration is obtained by frequency sweeping, i.e., the point F0 is obtained. The point F0 may be regarded as the first driving parameter.

At step 308, the drive circuit is controlled to drive the motor with the first driving parameter.

Relevant procedures in step 308 is similar as that in the example above in FIG. 1A, which is not repeatedly described herein.

The technical solution in the example is described in conjunction with FIG. 3C. In FIG. 3C, before a first time point corresponding to a dotted line 31, the motor 12 is in a non-vibrating state, and the gravitational acceleration collected by a gravity sensor 13 is equal to 0. At the first time point 31, the drive circuit 11 drives the motor to start vibrating. Amplitude of the gravitational acceleration for vibration of the motor 12 is continuously increased, and a cycle is continuously decreased. Accordingly, a frequency is continuously increased. A processor 10 obtains the first driving parameter (i.e., F0 in the example), and controls the drive circuit 11 to output a driving voltage with the frequency F0. At a second time point corresponding to a dotted line 32, the amplitude of the gravitational acceleration and the cycle of the gravitational acceleration is stable, which indicates that the vibration of the motor 12 is stable.

In the example, an electric signal is replaced by the vibration information with a mechanical property, and an optimum control for the alternating current motor may be implemented based on the drive circuit with the open-loop structure. The vibration information generated by the motor in the vibration mode can be collected by a component on the electronic device, thus, the vibration of the alternating current motor can reach a stable vibration state in a condition without a closed-loop structure. Further, compared with a drive circuit with the closed-loop structure, the cost of the drive circuit may be lower.

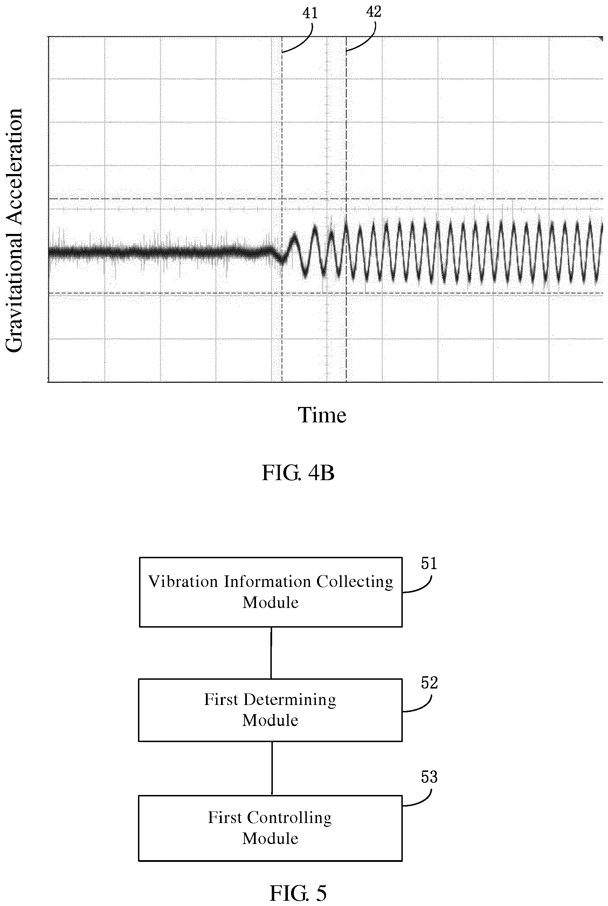

FIG. 4A is a flowchart illustrating a method of controlling vibration of a motor according to an example of the present disclosure. FIG. 4B is a schematic diagram illustrating distribution of a gravitational acceleration of a motor in a vibration mode according to an example in FIG. 4A. In the example, a type of the motor is a direct current motor, a driving parameter is a driving voltage outputted by the drive circuit, which is described in conjunction with FIG. 1B. In FIG. 4A, the method includes procedures as follows.

At step 401, vibration information generated by a motor in a vibration mode is collected.

Relevant procedures in step 401 is similar as that in the example above in FIG. 1A, which is not repeatedly described herein.

At step 402, a feature parameter of the vibration information in the vibration mode is determined.

At step 403, a second driving parameter corresponding to the feature parameter is searched for from preset reference information, where the preset reference information may include a correspondence between a feature parameter of motor operating in a stable state and a driving parameter used by the drive circuit.

Relevant procedures in steps 402 and 403 are similar as that in the example above in FIG. 2, which is not repeatedly described herein.

At step 404, a difference between the second driving parameter and a preset third driving parameter is determined, where the third driving parameter is a driving parameter used by the motor when the motor is working in a stable state.

At step 405, the first driving parameter for adjusting the drive circuit is determined based on the second driving parameter and the difference.

At step 406, the drive circuit is controlled to drive the motor using the first driving parameter.

In an illustrative scenario, a theoretical driving voltage desired for the motor 12 is 3V, which may be regarded as the third driving parameter in the example. Accordingly, the drive circuit 11 may provide the driving voltage of 3V, which may be regarded as an initial value of the first driving parameter in the example to the motor 12. Since the drive circuit 11 and the motor 12 are electrically connected via a wire which has inherent resistance, which may be referred to as wire resistance, between the drive circuit 11 and the motor 12, the driving voltage actually used by the motor 11 is reduced to 2.5V due to the wire resistance when the drive circuit 11 provides the driving voltage of 3V to the motor 12. A driving voltage value corresponding to the amplitude of the collected gravitational acceleration is 2.5 V, which may be referred to as the second driving parameter in the present disclosure. The driving voltage value may be searched out from the preset reference information.

Accordingly, the difference between the second driving parameter and the third driving parameter is 0.5V. When a preset threshold is 0.1V, the difference is more than the threshold, which indicates that the driving voltage provided from the drive circuit 11 to the motor 12 cannot reach the voltage which can make the motor 12 work in the stable state. The driving voltage outputted by the drive circuit 11 is adjusted based on the difference 0.5V. In particular, 0.5V may be taken as an offset to be added to the driving voltage 3.0V currently outputted by the drive circuit 11. The driving voltage provided from the drive circuit 11 to the motor 12 may be adjusted to 3.5V (i.e., the adjusted first driving parameter). By applying the above method iteratively, the adjustment for the driving voltage outputted by the drive circuit 11 is stopped until the difference between 3.0V and the driving voltage determined based on the vibration information/the preset reference information is less than the preset threshold. 0.1 V for example.

In an example in FIG, 4B, before a third time point corresponding to a dotted line 41, the motor 12 is in a non-vibrating state, and the gravitational acceleration acquired by a gravity sensor 13 is equal to zero. At the third time point corresponding to the dotted line 41, the drive circuit 11 drives the motor 12 to start vibrating. Afterwards, the amplitude of the gravitational acceleration for vibration of the motor 12 continuously is increased. A processor 10 obtains the second driving parameter, and controls the drive circuit 11 to adjust the output voltage of the drive circuit (i.e., the first driving parameter in the present disclosure) according to the second driving parameter and the difference between the third driving parameter and the second driving parameter. When the difference is less than the preset threshold, e.g., at the second time point corresponding to the dotted line 32, the amplitude of the gravitational acceleration is stable, which indicates that the motor 12 works in a stable state.

In the example, an electric signal is replaced by the vibration information with a mechanical property, and an optimum control for the direct current motor is implemented based on the drive circuit with the open-loop structure. The vibration information generated by the motor in the vibration mode can be collected by a component on the electronic device, thus, the vibration of the direct current motor can reach a stable vibration state in a condition without a closed-loop structure. Further, compared with a drive circuit with the closed-loop structure, the cost of the drive circuit is lower.

Sometimes, the adjusted the first driving parameter may be saved and may be used when the motor is entering a vibrating state again. For example, In the above example, the first driving parameter of 3.5V may be saved and the drive circuit may output 3.5V to drive the motor when the motor is entering the vibrating state again. By doing so, the motor may enter the optimum working condition faster than going through the process to determine the adjusted first driving parameter again.

Sometimes, even though the first driving parameter is saved and is used when the motor is entering a vibrating state again, the above determining steps may still be executed. By executing the determining steps, the driving parameter may be determined again. As such, the saved first driving parameter may be further adjusted when the saved first driving parameter is different from the determined first driving parameter as a result of executing the determining steps described above.

FIG. 5 is a schematic diagram illustrating a structure of an apparatus for controlling vibration of a motor according to an example of the present disclosure. As shown in FIG. 5, the apparatus for controlling vibration of a motor includes modules as follows.

A vibration information collecting module 51 may be configured to collect vibration information generated by the motor in a vibration mode.

A first determining module 52 may be configured to determine a first driving parameter outputted by a drive circuit of the motor according to the vibration information and preset reference information corresponding to a type of the motor, wherein the preset reference information may include a correspondence between a feature parameter of motor working in a stable state and a driving parameter used by motor working in the stable state.

A first controlling module 53 may be configured to control the drive circuit to drive the motor with the first driving parameter.

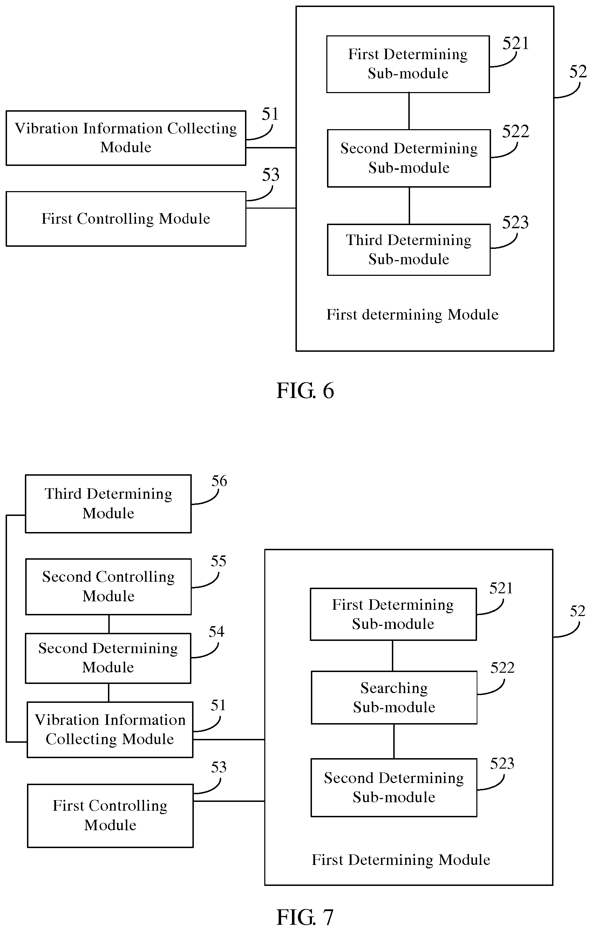

FIG. 6 is a schematic diagram illustrating a structure of an apparatus for controlling vibration of a motor according to an example of the present disclosure. Based on the example in FIG. 5, the first determining module 52 includes sub-modules as follows.

A first determining sub-module 521 may be configured to determine a feature parameter of the motor in the vibration mode according to the vibration information.

A second determining sub-module 522 may be configured to determine a second driving parameter corresponding to the feature parameter in the vibration mode determined by the first determining sub-module 521 based on the preset reference information.

A third determining sub-module 523 may be configured to determine the first driving parameter according to the second driving parameter determined by the second determining sub-module 522.

FIG. 7 is a schematic diagram illustrating a structure of an apparatus for controlling vibration of a motor according to an example of the present disclosure. In FIG. 7, the third determining sub-module 523 may be configured to:

determine whether the feature parameter corresponding to the second driving parameter reaches a maximum value of the feature parameter recorded in the preset reference information; and

determine a driving parameter outputted by the drive circuit to make the feature parameter of the motor reach the maximum value as the first driving parameter when the feature parameter corresponding to the second driving parameter reaches the maximum value of the feature parameter included in the preset reference information.

In an example, the apparatus further includes modules as follows.

A second determining module 54 may be configured to determine a preset range for the driving parameter used by the motor.

A second controlling module 55 may be configured to control the drive circuit to sequentially output driving parameters at a preset interval within the preset range to drive the motor with the driving parameters received at the preset interval.

The vibration information collecting module 51 may be configured to:
collect the vibration information generated by the motor driven with the driving parameters at the preset interval under the control of the second controlling module 55.

In an example, the third determining sub-module 523 may be configured to:
determine a difference between the second driving parameter and a preset third driving parameter, wherein the third driving parameter is a driving parameter used by the motor operating in a stable state; and
determine the first driving parameter based on the second driving parameter and the difference.

In an example, the third determining sub-module 523 may be configured to:
determine whether an absolute value of the difference is no less than a preset threshold;
adjust the first driving parameter according to the difference when the absolute value is no less than the preset threshold, where the adjustment is repeated until the absolute value of the difference between the second driving parameter and the preset third driving parameter is less than the preset threshold; and
execute the process of controlling the drive circuit to drive the motor with the first driving parameter when the absolute value is less than the preset threshold.

In an example, the apparatus further includes a module as follows.

A third determining module 56 may be configured to determine the type of the motor according to driving information for the drive circuit using an electronic device. And the vibration information collecting module 51 collects the vibration information corresponding to the type of the motor.

For apparatuses in the above examples, the functions in which different modules perform operations have been described in relevant methods examples, which are not repeatedly described herein.

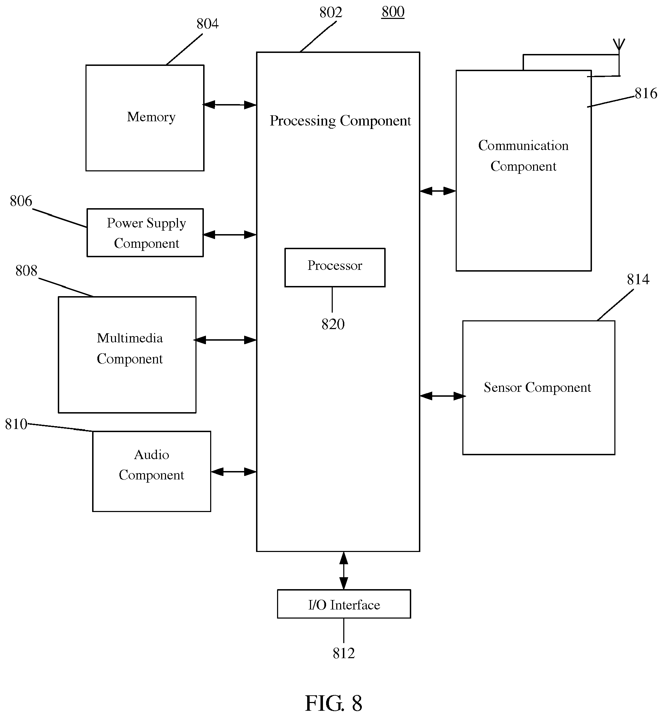

FIG. 8 is a schematic diagram illustrating a hardware structure of a device for controlling vibration of a motor according to an example of the present disclosure. For example, the device 800 may be an electronic device with a vibrating function such as a smart device and a tablet computer.

Referring to FIG. 8, the apparatus 800 may include one or more of the following components: a processing component 802, a memory 804, a power supply component 806, a multimedia component 808, an audio component 810, an input/output (I/O) interface 812, a sensor component 814, and a communication component 816.

The processing component 802 generally controls overall operations of the device 800, such as operations associated with display, phone calls, data communications, camera operations, and recording operations. The processing component 802 may include one or more processors 820 to execute instructions to perform all or part of the steps of the above method. In addition, the processing component 802 may include one or more modules which facilitate the interaction between the processing component 802 and other components. For example, the processing component 802 may include a multimedia module to facilitate the interaction between the multimedia component 808 and the processing component 802.

The memory 804 may be configured to store various types of data to support the operation of the apparatus 800. Examples of such data include instructions for any application or method operated on the apparatus 800, contact data, phonebook data, messages, pictures, videos, and so on. The memory 804 may be implemented by any type of volatile or non-volatile storage devices or a combination thereof, such as a Static Random Access Memory (SRAM), an Electrically Erasable Programmable Read-Only Memory (EEPROM), an Erasable Programmable Read-Only Memory (EPROM), a Programmable Read-Only Memory (PROM), a Read-Only Memory (ROM), a magnetic memory, a flash memory, a magnetic or optical disk.

The power supply component 806 may provide power to different components of the apparatus 800. The power supply component 806 may include a power management system, one or more power supplies, and other components associated with generating, managing, and distributing power for the apparatus 800.

The multimedia component 808 may include a screen providing an output interface between the apparatus 800 and a user. In some examples, the screen may include a Liquid Crystal Display (LCD) and a Touch Panel (TP). If the screen includes the TP, the screen may be implemented as a touch screen to receive input signals from the user. The TP may include one or more touch sensors to sense touches, slips, and gestures on the TP. The touch sensors may not only sense a boundary of a touch or slip action, but also sense a duration and a pressure associated with the touch or slip action. In some examples, the multimedia component 808 may include a front camera and/or a rear camera. The front camera and/or rear camera may receive external multimedia data when the apparatus 800 is in an operating mode, such as a photographing mode or a video mode. Each of the front camera and the rear camera may be a fixed optical lens system or have focal length and optical zooming capability.

The audio component 810 may be configured to output and/or input an audio signal. For example, the audio component 810 may include a microphone (MIC) configured to receive an external audio signal when the apparatus 800 is in an operating mode, such as a call mode, a recording mode, and a voice recognition mode. The received audio signal may be further stored in the memory 804 or sent via the communication component 816. In some examples, the audio component 810 further includes a speaker to output an audio signal.

The I/O interface 812 may provide an interface between the processing component 802 and peripheral interface modules. The above peripheral interface modules may include a keyboard, a click wheel, buttons, and so on. These buttons may include, but are not limited to, a home button, a volume button, a starting button, and a locking button.

The sensor component 814 may include one or more sensors to provide status assessments of various aspects for the apparatus 800. For example, the sensor component 814 may detect the on/off status of the apparatus 800, and relative positioning of component, for example, the component is a display and a keypad of the apparatus 800. The sensor component 814 may also detect a change in position of the apparatus 800 or one component of the apparatus 800, a presence or absence of the contact between a user and the apparatus 800, an orientation or an acceleration/deceleration of the apparatus 800, and a change in temperature of the device apparatus. The sensor component 814 may include a proximity sensor configured to detect the presence of a nearby object without any physical contact. The sensor component 814 may further include an optical sensor, such as a CMOS or CCD image sensor which is used in imaging applications. In some examples, the sensor component 814 may further include an acceleration sensor, a gyroscope sensor, a magnetic sensor, a pressure sensor, or a temperature sensor.

The communication component 816 may be configured to facilitate wired or wireless communication between the apparatus 800 and other devices. The apparatus 800 may access a wireless network that is based on a communication standard, such as Wi-Fi, 2G or 3G, or a combination thereof. In an example, the communication component 816 receives a broadcast signal or broadcast-associated information from an external broadcast management system via a broadcast channel. In an example, the communication component 816 further includes a Near Field Communication (NFC) module to facilitate short-range communications. For example, the NFC module may be implemented based on a Radio Frequency Identification (RFID) technology, an Infrared Data Association (IrDA) technology, an Ultra Wideband (UWB) technology, a Bluetooth (BT) technology and other technologies.

In an example, the apparatus 800 may be implemented by one or more Application Specific Integrated Circuits (ASICs), Digital Signal Processors (DSPs), Digital Signal Processing Devices (DSPDs), programmable Logic Devices (PLDs), Field Programmable Gate Arrays (FPGAs), controllers, microcontrollers, microprocessors, or other electronic components for performing the above method of controlling vibration of a motor.

Vibration information generated by the motor in a vibration mode is collected, a first driving parameter outputted by a drive circuit of the motor is determined according to the vibration information and preset reference information corresponding to a type of the motor, wherein the preset reference information records a correspondence between feature parameter of motor working in stable state and driving parameter used by motor working in stable state, and the drive circuit is controlled to drive the motor with the first driving parameter.

In an example, there is also provided a non-transitory machine-readable storage medium including instructions, such as a memory 804 including instructions. The above instructions may be executed by the processor 820 of the apparatus 800 to perform the above method. For example, the non-transitory machine-readable storage medium may be a ROM, a Random Access Memory (RAM), a CD-ROM, a magnetic tape, a floppy disk, and an optical data storage device and so on. The processor 820 may be configured to:
collect vibration information generated by the motor in a vibration mode; determine a first driving parameter outputted by a drive circuit of the motor according to the vibration information and preset reference information corresponding to a type of the motor, where the preset reference information may include a correspondence between a feature parameter of motor working in a astable state and a driving parameter used by motor working in the stable state; and control the drive circuit to drive the motor with the first driving parameter.

The present disclosure may include dedicated hardware implementations such as application specific integrated circuits, programmable logic arrays and other hardware devices. The hardware implementations can be constructed to implement one or more of the methods described herein. Applications that may include the apparatus and systems of various examples can broadly include a variety of electronic and computing systems. One or more examples described herein may implement functions using two or more specific interconnected hardware modules or devices with related control and data signals that can be communicated between and through the modules, or as portions of an application-specific integrated circuit. Accordingly, the computing system disclosed may encompass software, firmware, and hardware implementations. The terms "module," "sub-module," "circuit," "sub-circuit," "circuitry," "sub-circuitry," "unit," or "sub-unit" may include memory (shared, dedicated, or group) that stores code or instructions that can be executed by one or more processors.

Other implementations of the present disclosure will be apparent to those skilled in the art from consideration of the specification and practice of the present disclosure herein. The present disclosure is intended to cover any variations, uses, modification or adaptations of the present disclosure that follow the general principles thereof and include common knowledge or conventional technical means in the related art that are not disclosed in the present disclosure.

It is to be understood that the present disclosure is not limited to the precise structure described above and shown in the accompanying drawings, and that various modifications and changes may be made without departing from the scope of the invention, as defined by the claims.

## Claims

1. A method of controlling vibration of a motor, comprising:
collecting (101, 201, 401) vibration information generated by the motor when the motor is in a vibration mode;
determining (202, 402) a feature parameter of the motor in the vibration mode according to the vibration information;
determining (203, 403) a driving parameter corresponding to the feature parameter in the vibration mode based on a preset reference information, wherein the preset reference information corresponds to a type of the motor, and the preset reference information comprises a correspondence between the feature parameter of the motor and the driving parameter used by the motor when the motor is working in a stable state;
determining (204, 404-405) a target driving parameter according to the driving parameter; and
controlling (103) the drive circuit to drive the motor using the target driving parameter such that the motor works in a desired stable state, **characterized, in that**, when the type of the motor is a direct current motor, the driving parameter of the drive circuit is a driving voltage and when the type of the motor is an alternating current motor, the driving parameter of the drive circuit includes a driving voltage and a frequency corresponding to the driving voltage.

2. The method of claim 1, wherein determining the target driving parameter according to the driving parameter comprises:
determining (306) whether the feature parameter that corresponds to the driving parameter reaches a maximum value of the feature parameter included in the preset reference information;
determining (307) a driving parameter outputted by the drive circuit to make the feature parameter of the motor reach the maximum value as the target driving parameter when the feature parameter that corresponds to the driving parameter reaches the maximum value of the feature parameter included in the preset reference information.

3. The method of claim 2, further comprising:
determining (301) a preset range for the driving parameter for the motor;
controlling (302) the drive circuit to sequentially output driving parameters at a preset interval within the preset range to drive the motor;
collecting the vibration information generated by the motor in the vibration mode comprises:
collecting (303) the vibration information generated by the motor driven using the driving parameters at the preset interval.

4. The method of claim 1, wherein determining the target driving parameter according to the driving parameter comprises:
determining (404) a difference between the driving parameter and a preset desired driving parameter, wherein the desired driving parameter is a driving parameter used by the motor to operate in the stable state;
determining (405) the target driving parameter based on the driving parameter and the difference.

5. The method of claim 4, wherein determining the target driving parameter based on the driving parameter and the difference comprises:
determining whether an absolute value of the difference is no less than a preset threshold;
adjusting the driving parameter according to the difference when the absolute value is no less than the preset threshold, such that the absolute value of the difference between the driving parameter and the preset desired driving parameter is less than the preset threshold;
taking the driving parameter as the target driving parameter when the absolute value is less than the preset threshold;
controlling the drive circuit to drive the motor using the target driving parameter.

6. The method of claim 1, further comprising:
determining the type of the motor according to driving information of the drive circuit using an electronic device.

7. An apparatus for controlling vibration of a motor, comprising:
a vibration information collecting module (51), configured to collect vibration information generated by the motor when the motor is in a vibration mode;
a first determining sub-module (521), configured to determine a feature parameter of the motor in the vibration mode according to the vibration information;
a second determining sub-module (522), configured to determine a driving parameter corresponding to the feature parameter in the vibration mode based on the preset reference information wherein the preset reference information corresponds to a type of the motor, and the preset reference information comprises a correspondence between a feature parameter of the motor and a driving parameter used by the motor when the motor is working in a stable state;
a third determining sub-module (523), configured to determine a target driving parameter according to the driving parameter determined by the second determining sub-module (522); and
a first controlling module (53), configured to control the drive circuit to drive the motor using the target driving parameter such that the motor works in a desired stable state,
**characterized, in that**, when the type of the motor is a direct current motor, the driving parameter of the drive circuit is a driving voltage and when the type of the motor is an alternating current motor, the driving parameter of the drive circuit includes a driving voltage and a frequency corresponding to the driving voltage.

8. The apparatus of claim 7, wherein the third determining sub-module (523) is further configured to:
determine whether the feature parameter that corresponds to the driving parameter reaches a maximum value of the feature parameter included in the preset reference information; and
determine a driving parameter outputted by the drive circuit to make the feature parameter of the motor reach the maximum value as the target driving parameter when the feature parameter that corresponds to the driving parameter reaches the maximum value of the feature parameter included in the preset reference information.

9. The apparatus of claim 8, further comprising: a second determining module (54) and a second controlling module (55); wherein,
the second determining module (54) is configured to determine a preset range for the driving parameter for the motor;
the second controlling module (55) is configured to control the drive circuit to sequentially output driving parameters at a preset interval within the preset range to drive the motor; and
the vibration information collecting module (51) is configured to collect the vibration information generated by the motor driven using the driving parameters at the preset interval.

10. The apparatus of claim 7, wherein the third determining sub-module (523) is further configured to:
determine a difference between the driving parameter and a preset desired driving parameter, wherein the desired driving parameter is a driving parameter used by the motor to operate in the stable state; and
determine the target driving parameter based on the driving parameter and the difference.

11. The apparatus of claim 10, wherein the third determining sub-module (523) is further configured to:
determine whether an absolute value of the difference is no less than a preset threshold;
adjust the driving parameter according to the difference when the absolute value is no less than the preset threshold, such that the absolute value of the difference between the driving parameter and the preset desired driving parameter is less than the preset threshold;
taking the driving parameter as the target driving parameter when the absolute value is less than the preset threshold; and
control the drive circuit to drive the motor with the target driving parameter.

12. The apparatus of claim 7, wherein the third determining module (56) is further configured to:
determine the type of the motor according to driving information of the drive circuit using an electronic device.

## Patentansprüche

1. Verfahren zum Steuern der Vibration eines Motors mit den folgenden Schritten:
Sammeln (101, 201, 401) von Vibrationsinformationen, welche von dem Motor erzeugt werden, wenn sich der Motor in einem Vibrationsmodus befindet;
Bestimmen (202, 402) eines Merkmalsparameters des Motors im Vibrationsmodus gemäß den Vibrationsinformationen;
Bestimmen (203, 403) eines ersten Antriebsparameters entsprechend dem Merkmalsparameter im Vibrationsmodus auf der Basis von voreingestellten Referenzinformationen, wobei die voreingestellten Referenzinformationen einem Typ des Motors entsprechen, und die voreingestellten Referenzinformationen eine Entsprechung zwischen dem Merkmalsparameter des Motors und dem Antriebsparameter, den der Motor verwendet, wenn der Motor in einem stabilen Zustand arbeitet, aufweisen;
Bestimmen (204, 404-405) eines Ziel-Antriebsparameters entsprechend dem Antriebsparameter; und
Steuern (103) der Antriebsschaltung zum Antreiben des Motors unter Verwendung des Ziel-Antriebsparameters, derart, dass der Motor in einem gewünschten stabilen Zustand arbeitet,
**dadurch gekennzeichnet, dass**
wenn der Typ des Motors ein Gleichstrommotor ist, der Antriebsparameter der Antriebsschaltung eine Antriebsspannung ist, und wenn der Typ des Motors ein Wechselstrommotor ist, der Antriebsparameter der Antriebsschaltung eine Antriebsspannung und eine der Antriebsspannung entsprechende Frequenz aufweist.

2. Verfahren nach Anspruch 1, bei welchem das Bestimmen des Ziel-Antriebsparameters entsprechend dem Antriebsparameter die folgenden Schritte aufweist:
Feststellen (306), ob der Merkmalsparameter, der dem zweiten Antriebsparameter entspricht, einen Maximalwert des Merkmalsparameters erreicht, der in den voreingestellten Referenzinformationen enthalten ist;
Bestimmen (307) eines von der Antriebsschaltung ausgegebenen Antriebsparameters, um zu bewirken, dass der Merkmalsparameter des Motors den Maximalwert erreicht, als den Ziel-Antriebsparameter, wenn der Merkmalsparameter, der dem Antriebsparameter entspricht, den Maximalwert des in den voreingestellten Referenzinformationen enthaltenen Merkmalsparameters erreicht.

3. Verfahren nach Anspruch 2, ferner mit den folgenden Schritten:
Bestimmen (301) eines voreingestellten Bereichs für den Antriebsparameter für den Motor;
Steuern (302) der Antriebsschaltung zum sequentiellen Ausgeben von Antriebsparametern in einem voreingestellten Intervall innerhalb des voreingestellten Bereichs, um den Motor anzutreiben;
wobei das Sammeln der vom Motor im Vibrationsmodus erzeugten Vibrationsinformationen den folgenden Schritt aufweist:
Sammeln (303) der Vibrationsinformationen, die von dem unter Verwendung der Antriebsparameter angetriebenen Motors in dem voreingestellten Intervall erzeugt werden.

4. Verfahren nach Anspruch 1, bei welchem das Bestimmen des Ziel-Antriebsparameters entsprechend dem zweiten Antriebsparameter die folgenden Schritte aufweist:
Bestimmen (404) einer Differenz zwischen dem Antriebsparameter und einem voreingestellten gewünschten Antriebsparameter, wobei der gewünschte Antriebsparameter ein Antriebsparameter ist, der von dem Motor verwendet wird, um im stabilen Zustand zu arbeiten;
Bestimmen (405) des Ziel-Antriebsparameters basierend auf dem Antriebsparameter und der Differenz.

5. Verfahren nach Anspruch 4, bei welchem das Bestimmen des Ziel-Antriebsparameters basierend auf dem Fahrparameter und der Differenz die folgenden Schritte aufweist:
Feststellen, ob ein absoluter Wert der Differenz nicht geringer als ein voreingestellter Schwellenwert ist;
Einstellen des Antriebsparameters gemäß der Differenz, wenn der Absolutwert nicht geringer als der voreingestellte Schwellenwert ist, so dass der Absolutwert der Differenz zwischen dem Antriebsparameter und dem voreingestellten gewünschten Antriebsparameter geringer als der voreingestellte Schwellenwert ist;
Verwenden des Antriebsparameters als den Ziel-Antriebsparameter, wenn der Absolutwert geringer als der voreingestellte Schwellenwert ist;
Steuern der Antriebsschaltung zum Antreiben des Motors unter Verwendung des Ziel-Antriebsparameters.

6. Verfahren nach Anspruch 1, ferner mit dem Schritt:
Bestimmen des Motortyps entsprechend den Antriebsinformationen der Antriebsschaltung unter Verwendung eines elektronischen Geräts.

7. Vorrichtung zum Steuern der Vibration eines Motors, mit:
einem Vibrationsinformationensammelmodul (51), das dazu ausgebildet ist, Vibrationsinformationen zu sammeln, die von dem Motor erzeugt werden, wenn sich der Motor in einem Vibrationsmodus befindet;
einem ersten Bestimmungs-Submodul (521), das dazu ausgebildet ist, einen Merkmalsparameter des Motors in dem Vibrationsmodus entsprechend den Vibrationsinformationen zu bestimmen;
einem zweiten Bestimmungs-Submodul (522), das dazu ausgebildet ist, einen ersten Antriebsparameter, der dem Merkmalsparameter in dem Vibrationsmodus entspricht, basierend auf den voreingestellten Referenzinformationen zu bestimmen, wobei die voreingestellten Referenzinformationen einem Typ des Motors entsprechen, und wobei die voreingestellten Referenzinformationen eine Entsprechung zwischen einem Merkmalsparameter des Motors und einem Antriebsparameter aufweisen, der von dem Motor verwendet wird, wenn der Motor in einem stabilen Zustand arbeitet;
einem dritten Bestimmungs-Submodul (523), das dazu ausgebildet ist, einen Ziel-Antriebparameter entsprechend dem von dem zweiten Bestimmungs-Submodul (522) bestimmten Antriebsparameter zu bestimmen; und
einem ersten Steuermodul (53), das dazu ausgebildet ist, die Antriebsschaltung zu steuern, um den Motor unter Verwendung des ersten Antriebsparameters derart anzutreiben, dass der Motor in einem gewünschten stabilen Zustand arbeitet,
**dadurch gekennzeichnet, dass**
wenn der Typ des Motors ein Gleichstrommotor ist, der Antriebsparameter der Antriebsschaltung eine Antriebsspannung ist, und wenn der Typ des Motors ein Wechselstrommotor ist, der Antriebsparameter der Antriebsschaltung eine Antriebsspannung und eine der Antriebsspannung entsprechende Frequenz aufweist.

8. Vorrichtung nach Anspruch 7, bei welcher das dritte Bestimmungs-Submodul (523) ferner dazu ausgebildet ist,
festzustellen, ob der Merkmalsparameter, der dem Antriebsparameter entspricht, einen Maximalwert des Merkmalsparameters, der in den voreingestellten Referenzinformationen enthalten ist, erreicht; und
einen von der Antriebsschaltung ausgegebenen Antriebsparameter als den Ziel-Antriebsparameter zu bestimmen, um zu bewirken, dass der Merkmalsparameter des Motors den Maximalwert erreicht, wenn der Merkmalsparameter, der dem Antriebsparameter entspricht, den Maximalwert des in den voreingestellten Referenzinformationen enthaltenen Merkmalsparameters erreicht.

9. Vorrichtung nach Anspruch 8, ferner mit:
einem zweiten Bestimmungsmodul (54) und einem zweiten Steuermodul (55), wobei:
das zweite Bestimmungsmodul (54) dazu ausgebildet ist, einen voreingestellten Bereich für den Antriebsparameter für den Motor zu bestimmen;
das zweite Steuermodul (55) dazu ausgebildet ist, die Antriebsschaltung zum sequentiellen Ausgeben von Antriebsparametern in einem voreingestellten Intervall innerhalb des voreingestellten Bereichs auszugeben, um den Motor anzutreiben; und
das Vibrationsinformationensammelmodul (51) dazu ausgebildet ist, die von dem unter Verwendung der Antriebsparameter angetriebenen Motor erzeugten Vibrationsinformationen im voreingestellten Intervall zu sammeln.

10. Vorrichtung nach Anspruch 7, bei welcher das dritte Bestimmungs-Submodul (523) ferner dazu ausgebildet ist,
eine Differenz zwischen dem Antriebsparameter und einem voreingestellten gewünschten Antriebsparameter zu bestimmen, wobei der gewünschte Antriebsparameter ein Antriebsparameter ist, der vom Motor verwendet wird, um in dem stabilen Zustand zu arbeiten; und
den Ziel-Antriebsparameter auf der Basis des zweiten Antriebsparameters und der Differenz zu bestimmen.

11. Vorrichtung nach Anspruch 10, bei welcher das dritte Bestimmungs-Submodul (523) ferner dazu ausgebildet ist,
festzustellen, ob ein absoluter Wert der Differenz nicht geringer als ein voreingestellter Schwellenwert ist;
den Antriebsparameter entsprechend der Differenz einzustellen, wenn der Absolutwert nicht geringer als der voreingestellte Schwellenwert ist, so dass der Absolutwert der Differenz zwischen dem Antriebsparameter und dem voreingestellten gewünschten Antriebsparameter geringer als der voreingestellte Schwellenwert ist;
den Antriebsparameter als den Ziel-Antriebsparameter zu verwenden, wenn der Absolutwert geringer als der voreingestellte Schwellenwert ist; und
die Antriebsschaltung zu steuern, um den Motor mit dem Ziel-Antriebsparameter anzutreiben.

12. Vorrichtung nach Anspruch 7, das dritte Bestimmungs-Submodul (523) ferner dazu ausgebildet ist,
den Motortyp auf der Basis der Antriebsinformationen der Antriebsschaltung unter Verwendung eines elektronischen Geräts zu bestimmen.

## Revendications

1. Procédé de régulation de la vibration d'un moteur, comprenant le fait de:
collecter (101, 201, 401) les informations de vibration générées par le moteur lorsque le moteur se trouve dans un mode de vibration;
déterminer (202, 402) un paramètre de caractéristique du moteur en mode de vibration selon les informations de vibration;
déterminer (203, 403) un paramètre de pilotage correspondant au paramètre de caractéristique en mode de vibration sur base des informations de référence préétablies, où les informations de référence préétablies correspondent à un type de moteur, et les informations de référence préétablies comprennent une correspondance entre le paramètre de caractéristique du moteur et le paramètre de pilotage utilisé par le moteur lorsque le moteur fonctionne dans un état stable;
déterminer (204, 404-405) un paramètre de pilotage cible selon le paramètre de pilotage; et
commander (103) le circuit de pilotage pour commander le moteur à l'aide du paramètre de pilotage cible de sorte que le moteur fonctionne dans un état stable souhaité,
**caractérisé par le fait que**, lorsque le type du moteur est un moteur à courant continu, le paramètre de pilotage du circuit de pilotage est une tension de pilotage et que, lorsque le type de moteur est un moteur à courant alternatif, le paramètre de pilotage du circuit de pilotage comporte une tension de pilotage et une fréquence correspondant à la tension de pilotage.

2. Procédé selon la revendication 1, dans lequel la détermination du paramètre de pilotage cible selon le paramètre de pilotage comprend le fait de:
déterminer (306) si le paramètre de caractéristique qui correspond au paramètre de pilotage atteint une valeur maximale du paramètre de caractéristique inclus dans les informations de référence préétablies;
déterminer (307) un paramètre de pilotage sorti par le circuit de pilotage pour amener le paramètre de caractéristique du moteur à atteindre la valeur maximale comme paramètre de pilotage cible lorsque le paramètre de caractéristique qui correspond au paramètre de pilotage atteint la valeur maximale du paramètre de caractéristique inclus dans les informations de référence préétablies.

3. Procédé selon la revendication 2, comprenant par ailleurs le fait de:
déterminer (301) une plage préétablie pour le paramètre de pilotage pour le moteur;
commander (302) le circuit de pilotage pour sortir en séquence les paramètres de pilotage à un intervalle préétabli dans la plage préétablie pour entraîner le moteur;
la collecte des informations de vibration générées par le moteur en mode de vibration comprend le fait de:
collecter (303) les informations de vibration générées par le moteur entraîné à l'aide des paramètres de pilotage à l'intervalle préétabli.

4. Procédé selon la revendication 1, dans lequel la détermination du paramètre de pilotage cible selon le paramètre de pilotage comprend le fait de:
déterminer (404) une différence entre le paramètre de pilotage et un paramètre de pilotage souhaité préétabli, où le paramètre préétabli souhaité est un paramètre de pilotage utilisé par le moteur pour fonctionner dans l'état stable;
déterminer (405) le paramètre de pilotage cible sur base du paramètre de pilotage et de la différence.

5. Procédé selon la revendication 4, dans lequel la détermination du paramètre de pilotage cible sur base du paramètre de pilotage et de la différence comprend le fait de:
déterminer si une valeur absolue de la différence n'est pas inférieure à un seuil préétabli;
ajuster le paramètre de pilotage selon la différence lorsque la valeur absolue n'est pas inférieure au seuil préétabli, de sorte que la valeur absolue de la différence entre le paramètre de pilotage et le paramètre de pilotage souhaité préétabli soit inférieure au seuil préétabli;
prendre le paramètre de pilotage comme paramètre de pilotage cible lorsque la valeur absolue est inférieure au seuil préétabli;
commander le circuit de pilotage pour entraîner le moteur à l'aide du paramètre de pilotage cible.

6. Procédé selon la revendication 1, comprenant par ailleurs le fait de:
déterminer le type du moteur selon les informations de commande du circuit de pilotage à l'aide d'un dispositif électronique.

7. Appareil pour réguler la vibration d'un moteur, comprenant:
un module de collecte d'informations de vibration (51) configuré pour collecter les informations de vibration générées par le moteur lorsque le moteur se trouve dans un mode de vibration;
un premier sous-module de détermination (521) configuré pour déterminer un paramètre de caractéristique du moteur en mode de vibration selon les informations de vibration;
un deuxième sous-module de détermination (522) configuré pour déterminer un paramètre de pilotage correspondant au paramètre de caractéristique en mode de vibration sur base des informations de référence préétablies, où les informations de référence préétablies correspondent à un type de moteur, et les informations de référence préétablies comprennent une correspondance entre un paramètre de caractéristique du moteur et un paramètre de pilotage utilisé par le moteur lorsque le moteur fonctionne dans un état stable;
un troisième sous-module de détermination (523) configuré pour déterminer un paramètre de pilotage cible selon le paramètre de pilotage déterminé par le deuxième sous-module de détermination (522); et
un premier module de commande (53) configuré pour commander le circuit de pilotage pour entraîner le moteur à l'aide du paramètre de pilotage cible de sorte que le moteur fonctionne dans un état stable souhaité,
**caractérisé par le fait que**, lorsque le type du moteur est un moteur à courant continu, le paramètre de pilotage du circuit de pilotage est une tension de pilotage et que, lorsque le type de moteur est un moteur à courant alternatif, le paramètre de pilotage du circuit de pilotage comprend une tension de pilotage et une fréquence correspondant à la tension de pilotage.

8. Appareil selon la revendication 7, dans lequel le troisième sous-module de détermination (523) est par ailleurs configuré pour:
déterminer si le paramètre de caractéristique qui correspond au paramètre de pilotage atteint une valeur maximale du paramètre de caractéristique inclus dans les informations de référence préétablies; et
déterminer un paramètre de pilotage sorti par le circuit de commande pour amener le paramètre de caractéristique du moteur à atteindre la valeur maximale comme paramètre de pilotage cible lorsque le paramètre de caractéristique qui correspond au paramètre de pilotage atteint la valeur maximale du paramètre de caractéristique inclus dans les informations de référence préétablies.

9. Appareil selon la revendication 8, comprenant par ailleurs: un deuxième module de détermination (54) et un deuxième module de commande (55); dans lequel
le deuxième module de détermination (54) est configuré pour déterminer une plage préétablie pour le paramètre de pilotage pour le moteur;
le deuxième module de commande (55) est configuré pour commander le circuit de pilotage pour sortir en séquence les paramètres de pilotage à un intervalle préétabli dans la plage préétablie pour entraîner le moteur; et
le module de collecte d'informations de vibration (51) est configuré pour collecter les informations de vibration générées par le moteur entraîné à l'aide des paramètres de pilotage à l'intervalle préétabli.

10. Appareil selon la revendication 7, dans lequel le troisième sous-module de détermination (523) est par ailleurs configuré pour:
déterminer une différence entre le paramètre de pilotage et un paramètre de pilotage souhaité préétabli, où le paramètre de pilotage souhaité est un paramètre de pilotage utilisé par le moteur pour fonctionner dans l'état stable; et
déterminer le paramètre de pilotage cible sur base du paramètre de pilotage et de la différence.

11. Appareil selon la revendication 10, dans lequel le troisième sous-module de détermination (523) est par ailleurs configuré pour:
déterminer si une valeur absolue de la différence n'est pas inférieure à un seuil préétabli;
ajuster le paramètre de pilotage selon la différence lorsque la valeur absolue n'est pas inférieure au seuil préétabli, de sorte que la valeur absolue de la différence entre le paramètre de pilotage et le paramètre de pilotage souhaité préétabli soit inférieure au seuil préétabli;
prendre le paramètre de pilotage comme paramètre de pilotage cible lorsque la valeur absolue est inférieure au seuil préétabli; et
commander le circuit de pilotage pour entraîner le moteur par le paramètre de pilotage cible.

12. Appareil selon la revendication 7, dans lequel le troisième module de détermination (56) est par ailleurs configuré pour:
déterminer le type de moteur selon les informations de commande du circuit de pilotage à l'aide d'un dispositif électronique.
